# EUROPÄISCHE PATENTSCHRIFT

(11) **EP 2 306 534 B1**
(45) Veröffentlichungstag und Bekanntmachung des Hinweises auf die Patenterteilung: **12.11.2014**
(21) Anmeldenummer: 10178335.5
(22) Anmeldetag: 22.09.2010
(51) Int. Cl.: H01L 35/00, F24C 7/00

(54) **Hausgerät mit einer sich im Betrieb erwärmenden Komponente und einer Kühlvorrichtung sowie Verfahren zum Kühlen einer sich im Betrieb erwärmenden weiteren Komponente eines Hausgeräts**
Domestic appliance with a component that heats up during operation and a cooling device and method for cooling a further component of a domestic appliance that heats up during operation
Appareil ménager doté d'un composant chauffant en fonctionnement et d'un dispositif de refroidissement ainsi que procédé de refroidissement d'un autre composant chauffant en fonctionnement d'un appareil ménager

(30) Priorität: 02.10.2009 DE 102009045288
(43) Veröffentlichungstag der Anmeldung: 06.04.2011
(73) Patentinhaber: BSH Bosch und Siemens Hausgeräte GmbH, 81739 München (DE)
(72) Erfinder: Dengler, Klaus, 83471, Schönau am Königssee (DE); Hangl, Felix, 83329, Waging am See (DE); Steinbeck, Martin-Ernst, 83342 Tacherting (DE); de Vries, Markus, 83278, Traunstein (DE)

(56) Entgegenhaltungen:
- EP-A2- 1 601 236
- WO-A2-2006/103613
- DE-A1-102004 028 983
- DE-U1-202005 014 163
- JP-A- 2009 121 797
- US-A- 5 921 087
- US-A1- 2007 056 622
- US-A1- 2008 245 352
- US-B1- 6 279 464

## Beschreibung

Die Erfindung betrifft ein Hausgerät mit einer sich im Betrieb erwärmenden ersten Komponente und einer Kühlvorrichtung zum Kühlen zumindest einer zweiten Komponente. Des Weiteren betrifft die Erfindung ein Verfahren zum Kühlen einer zweiten Komponente des Hausgeräts.

Hausgeräte, wie Backöfen und Elektroherde, weisen Komponenten auf, die sich im Betrieb erwärmen. In diesem Zusammenhang sind beispielsweise die Backoffenmuffel oder aber auch elektronische Komponenten und Motoren, genannt. Zur Kühlung von elektronischen Bauteilen oder Motoren werden Gebläse eingesetzt. Diese sind jedoch mit elektrischer Energie zu versorgen.

Aus der US 2009/002573 A1 sind Peltier-Elemente bekannt, die mit einer thermisch beaufschlagten Komponente verbunden sind und aufgrund einer Temperaturdifferenz elektrischen Strom erzeugen. Das Peltier-Element ist dabei mit zwei mit unterschiedlichen Temperaturen beaufschlagten Platten kontaktiert, um diese Temperaturdifferenz erzeugen zu können. Darüber hinaus ist aus der US 2008/0245352 A1 und der WO2006/103613 A2 der Einsatz eines Peltier-Elements in einem Ofen, welcher mit Holz geheizt wird, bekannt. Auch wird das Peltier-Element einerseits mit einer warmen Platte und andererseits mit einer kalten Platte kontaktiert, um aufgrund dieser Temperaturdifferenz elektrischen Strom zu erzeugen. Um die Temperaturdifferenz relativ groß zu gestalten, wird die kühlere Platte des Weiteren noch mit einem Gebläse gekühlt.

Es ist Aufgabe der vorliegenden Erfindung, ein Hausgerät so auszugestalten, dass es energieeffizienter betrieben werden kann.

Diese Aufgabe wird durch ein Hausgerät, welches die Merkmale nach Anspruch 1 aufweist, und ein Verfahren, welches die Merkmale nach Anspruch 12 aufweist, gelöst.

Ein erfindungsgemäßes Hausgerät weist eine sich im Betrieb erwärmende erste Komponente auf. Darüber hinaus umfasst das Hausgerät eine Kühlvorrichtung zum Kühlen zumindest einer zweiten Komponente. Die Kühlvorrichtung ist mit der ersten Komponente des Hausgeräts thermisch gekoppelt und die Kühlvorrichtung ist darüber hinaus zur Umwandlung der Wärme der ersten Komponente in elektrischen Strom und zur Umwandlung des Stroms zur Kühlung der zweiten Komponente ausgebildet. Die Kühlvorrichtung ist dahingehend ausgelegt und konzipiert, dass sie mit den beiden sich im Betrieb erwärmenden separaten Komponenten gekoppelt ist und ermöglicht durch Energieumwandlung von Wärme in Strom und von Strom in Kühlung die effektive Energienutzung. Von einer Komponente des Hausgeräts abgegebene Energie, nämlich Wärme kann somit sinnvoll umgewandelt und genutzt werden, um eine andere Komponente zu kühlen. Ein energieeffizienter Betrieb des Hausgeräts ist dadurch gegeben.

Die Kühlvorrichtung weist ein erstes Peltier-Element auf, welches mit der ersten Komponente kontaktiert ist und zur Umwandlung der Wärme der ersten Komponente in elektrischen Strom betrieben ist. Gerade derartige Elemente sind sehr klein und kompakt aufgebaut und ermöglichen durch Kontaktierung mit einer wärmebeaufschlagten Komponente und der Kontaktierung anderseits mit einem kühleren Medium die Erzeugung einer Temperaturdifferenz, wobei aufgrund dieser Temperaturdifferenz und der Wirkungsweise eines derartigen Peltier-Elements ein elektrischer Strom erzeugt wird. Diese Funktionsweise ist auch durch den Seebeck-Effekt bekannt. Das Peltier-Element ist insbesondere auch mit einer gegenüber der ersten Komponente auf einem kälteren Temperaturniveau befindlichen Medium, beispielsweise einer Gehäusewand des Hausgeräts, kontaktiert, um die Temperaturdifferenz auszubilden, auf Grundlage derer der elektrische Strom erzeugt wird.

Das Hausgerät ist ein Backofen, welcher als erste Komponente eine Muffel aufweist, wobei das erste Peltier-Element an der Muffel, insbesondere außerhalb an einer Muffeldecke angeordnet ist. Dies ist eine besonders vorteilhafte Position, da im Hinblick auf die thermische Beaufschlagung des Peltier-Elements zur Stromerzeugung auch eine besonders große Temperaturdifferenz erzeugt und somit auch eine besonders große elektrische Stromgenerierung möglich ist.

Vorzugsweise weist die Kühlvorrichtung eine Kühleinheit auf, welche durch das Anlegen des elektrischen Stroms zum Kühlen der zweiten Komponente ausgebildet ist. Es kann vorgesehen sein, dass diese Kühleinheit ein Kühlluftgebläse ist. Es kann somit vorgesehen sein, dass diese Ausgestaltung des Kühlluftgebläses mit dem ersten Peltier-Element verbunden ist und durch dieses erste Peltier-Element mit elektrischem Strom versorgt ist.

Besonders vorteilhaft ist es, wenn die Kühleinheit ein zweites Peltier-Element ist, welches mit der zweiten Komponente kontaktiert ist und welches durch Anlegen des elektrischen Stroms zur Erzeugung einer Temperaturdifferenz ausgebildet ist, durch welche die zweite Komponente kühlbar ist. Gerade eine derartige Ausgestaltung ist energiespezifisch und bauraumminimiert besonders geeignet. Das Zusammenspiel zweier Peltier-Elemente, welche invers betrieben werden und miteinander gekoppelt werden, gewährleistet durch die Wärmeumwandlung die Erzeugung elektrischen Stroms der wiederum genutzt werden kann, um das zweite Peltier-Element mit elektrischer Energie zu versorgen, wodurch dieses aufgrund seiner Auslegung und Funktionsweise eine Temperaturdifferenz generiert, die einen Kühleffekt an der zweiten Komponente erzeugt.

Vorzugsweise sind die beiden Peltier-Elemente direkt elektrisch miteinander verbunden. Dies ist besonders bauteilsparend und kompakt.

Des Weiteren ist vorzugsweise vorgesehen, dass das Hausgerät eine Energierückgewinnungsvorrichtung aufweist, welche mit der ersten Komponente thermisch gekoppelt ist und zur Umwandlung von Wärme der ersten Komponente in elektrische Energie ausgebildet ist. Darüber hinaus umfasst das Hausgerät eine Einrichtung als elektrischen Verbraucher des Hausgeräts, welche mit der Energierückgewinnungsvorrichtung gekoppelt ist, und welche die elektrische Energie bereitstellt. Die Einrichtung ist vorzugsweise die zweite sich im Betrieb erwärmende Komponente des Hausgeräts. Es kann jedoch auch vorgesehen sein, dass zusätzlich zu den beiden Komponenten des Hausgeräts die separate Einrichtung vorhanden ist.

Durch die Energierückgewinnungsvorrichtung wird ebenfalls der energieeffiziente Betrieb des Hausgeräts verbessert, da nicht zusätzliche externe Energie über ein Versorgungsnetz bereitgestellt werden muss, sondern dass zumindest die Einrichtung zumindest anteilig mit durch das Hausgerät selbst erzeugten elektrischen Strom versorgt werden kann.

In besonders vorteilhafter Weise ist vorgesehen, dass die Energierückgewinnungsvorrichtung als Notstromvorrichtung ausgebildet ist, durch welche die Einrichtung mit Energie versorgt ist, wenn durch das externe Versorgungsnetz, mit welchem das Hausgerät verbunden ist, keine oder keine ausreichende Energieversorgung gegeben ist. Die Energierückgewinnungsvorrichtung arbeitet in besonders vorteilhafter Weise also dann, wenn durch das externe Versorgungsnetz eine Unterversorgung mit Energie zumindest der Einrichtung des Hausgeräts gegeben ist. Insbesondere fungiert die Energierückgewinnungsvorrichtung somit als Notstromaggregat, welches den erzeugten elektrischen Strom im Hausgerät quasi selbst erzeugt.

Besonders vorteilhaft ist dies bei einem Hausgerät, welches als Backofen ausgebildet ist und einen Pyrolysebetrieb aufweist. Gerade im Pyrolysebetrieb ist die Betriebssicherheit besonders hoch zu gewährleisten, so dass hier Energieausfälle vermieden werden müssen. Da beim Pyrolysebetrieb auch besonders hohe Temperaturen im Hausgerät auftreten, können somit durch die Funktionsweise der Energierückgewinnungsvorrichtung insbesondere wenn sie Peltier-Elemente aufweist, besonders vorteilhaft ermöglicht werden. Da beim Pyrolysebetrieb insbesondere die Muffel des Backofens besonders heiß wird, kann hier auch eine besonders intensive Wärmequelle genutzt werden, um elektrischen Strom durch die Energierückgewinnungsvorrichtung zu erzeugen und der dann bei einem möglichen Netzausfall im Pyrolysebetrieb anderen Einrichtungen zur Verfügung gestellt werden kann und der Pyrolysebetrieb fortgesetzt werden kann.

Vorzugsweise weist das Hausgerät eine Steuereinheit auf, durch welche die Versorgung des Hausgeräts durch das Versorgungsnetz überwacht ist und durch welche die Betriebsart der Energierückgewinnungsvorrichtung steuerbar ist. Es kann also auch hier explizit vorgesehen sein, wann die Energierückgewinnungsvorrichtung betrieben werden soll und/oder wann sie Strom an eine Einrichtung oder weitere Komponenten des Hausgeräts liefern soll. Diesbezüglich kann eine spezifische Betriebsart der Energierückgewinnungsvorrichtung durch die Steuereinheit eingestellt werden.

Es kann auch vorgesehen sein, dass das Hausgerät eine Energiespeichereinheit aufweist, in welche zumindest anteilig die von der Energierückgewinnungsvorrichtung erzeugte elektrische Energie gespeichert wird.

Vorzugsweise weisen die Kühlvorrichtung und die Energierückgewinnungsvorrichtung ein funktionell beiden Vorrichtungen zugeordnetes Element, insbesondere das erste Peltier-Element auf, welches zur Umwandlung der Wärme der ersten Komponente in elektrischen Strom ausgebildet ist. Der erzeugte Strom ist abhängig vom Bedarf der zu kühlenden zweiten Komponente und/oder abhängig von Betriebsphasen des Hausgeräts zumindest anteilig der Kühlvorrichtung und/oder zumindest anteilig der Energierückgewinnungsvorrichtung bereitstellbar. Dies bedeutet es kann somit sehr flexibel und situationsabhängig die erzeugte elektrische Energie zugeteilt und dosiert werden. Ist ein großer Kühlbedarf erforderlich, so kann die Energie vollständig der Kühlvorrichtung zugeteilt werden, wobei dies insbesondere dann vorteilhaft ist, wenn keine anderweitige Komponente mit Energie zwingend zu versorgen ist, und insbesondere wenn ein Netzausfall vorliegt.

Gerade dann, wenn auch das zweite Peltier-Element vorhanden ist, kann dies einerseits sowohl mit Energie versorgt werden und andererseits auch zur Kühlung einer Komponente beitragen. Grundsätzlich kann damit auch im nicht vorhandenen Notfall und somit nicht nur bei einer Notstromversorgung, die erzeugte elektrische Energie sofort für die Versorgung einer anderen Einrichtung und Komponente im Hausgerät verwendet werden.

Auch bei normaler Netzstromversorgung kann somit zumindest dieser Anteil an elektrischer Energie von extern eingespart werden.

Vorzugsweise ist die zu kühlende zweite Komponente ein Bedienmodul, insbesondere ein elektronischer Schaltungsträger und/oder ein Motor. Die Erfindung betrifft auch ein Verfahren zum Kühlen einer sich im Betrieb erwärmenden zweiten Komponente eines Hausgeräts, welche eine sich im Betrieb erwärmende erste Komponente aufweist, bei welchem das Kühlen mittels einer Kühlvorrichtung durchgeführt wird. Die Kühlvorrichtung wird mit der ersten Komponente thermisch gekoppelt und die Wärme der ersten der Strom für eine Kühleinheit der Kühlvorrichtung bereitgestellt wird und mit der Kühleinheit die zweite Komponente gekühlt wird.

Vorzugsweise wird die Kühlvorrichtung mit einem ersten Peltier-Element ausgebildet, welches mit der ersten Komponenten thermisch kontaktiert wird und zur Umwandlung der Wärme der ersten Komponente in elektrischen Strom betrieben wird, wobei die Kühleinheit ein zweites Peltier-Element ist, welches mit dem ersten Peltier-Element elektrisch verbunden und mit der zweiten Komponente kontaktiert wird und welches durch Anlegen des elektrischen Stroms eine Temperaturdifferenz erzeugt, durch welche die zweite Komponente gekühlt wird.

Insbesondere wird das erste Peltier-Element mit einer als erste Komponente ausgebildeten Muffel eines Backofens thermisch kontaktiert und durch das zweite Peltier-Element ein als zweite Komponente ausgebildetes Bedienmodul des Backofens gekühlt.

Die Erfindung betrifft auch ein Verfahren zum Kühlen einer sich im Betrieb erwärmenden zweiten Komponente eines Hausgeräts, welches eine sich im Betrieb erwärmende erste Komponente aufweist, bei welchem das Kühlen mittels einer Kühlvorrichtung durchgeführt wird. Die Kühlvorrichtung wird mit der ersten Komponente thermisch gekoppelt und die Wärme der ersten Komponente durch die Kühlvorrichtung in elektrischen Strom umgewandelt, wobei der Strom für eine Kühleinheit der Kühlvorrichtung bereitgestellt wird und mit der Kühleinheit die zweite Komponente gekühlt wird.

Vorteilhafte Ausgestaltungen des erfindungsgemäßen Hausgeräts sind als vorteilhafte Ausgestaltung des erfindungsgemäßen Verfahrens anzusehen.

Weitere Merkmale der Erfindung ergeben sich aus den Ansprüchen, den Figuren und der Figurenbeschreibung. Die vorstehend in der Beschreibung genannten Merkmale und Merkmalskombinationen als auch die in der Figurenbeschreibung und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

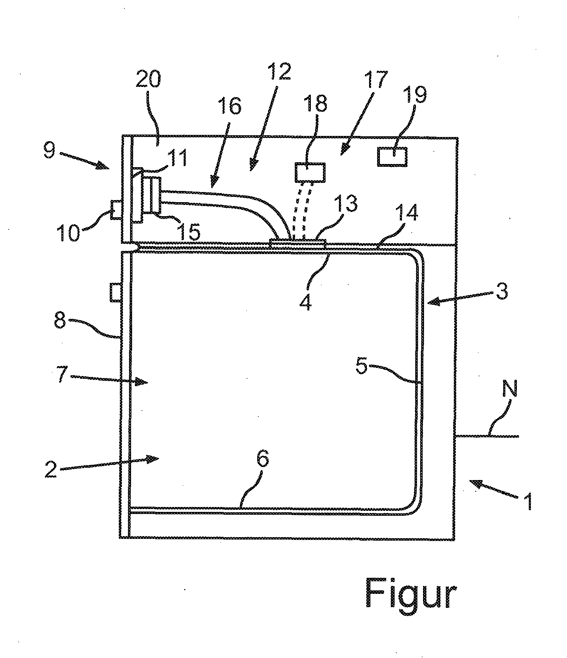

Ein Ausführungsbeispiel der Erfindung wird nachfolgend anhand einer schematischen Zeichnung näher erläutert. Die einzige Figur zeigt in vereinfachter Weise eine seitliche Schnittdarstellung durch ein Hausgerät, welches als Backofen 1 ausgebildet ist.

Der Backofen 1 weist einen Garraum 2 auf, welcher durch eine Muffel 3 begrenzt ist, wobei die Muffel 3 eine Decke 4, eine Rückwand 5 und einen Boden 6 sowie nicht weiter gekennzeichnete Seitenwände aufweist. Frontseitig ist die Muffel 3 geöffnet und weist eine Beschickungsöffnung 7 auf, welche durch eine Tür 8 verschließbar ist. Darüber hinaus umfasst der Backofen 1 ein Bedienmodul 9, welches eine Mehrzahl von Bedienelementen 10 aufweist. Über das Bedienmodul 9 können Betriebsfunktionen und Betriebsparametereinstellungen durchgeführt werden. Das Bedienmodul 9 umfasst einen Schaltungsträger 10, auf dem elektronische Bauteile angeordnet sind. Sowohl die als erste Komponente ausgebildete Muffel 3 als auch das separat dazu ausgebildete und angeordnete Bedienmodul 9, welches die zweite Komponente darstellt, sind sich im Betrieb erwärmende Komponenten.

Der Backofen 1 umfasst darüber hinaus eine Kühlvorrichtung 12, welche zum Kühlen des Bedienmoduls 9, insbesondere des Schaltungsträgers 10 ausgebildet ist. Die Kühlvorrichtung 12 umfasst ein erstes Peltier-Element 13. Dieses erste Peltier-Element 13 ist thermisch mit der Muffel 3 kontaktiert und im Ausführungsbeispiel direkt an der Außenseite 14 der Decke 4 angeordnet.

Die Kühlvorrichtung 12 umfasst darüber hinaus ein zweites Peltier-Element 15, welches in direktem thermischen Kontakt mit dem Schaltungsträger 11 angeordnet ist. Die beiden Peltier-Elemente 13 und 15 sind elektrisch miteinander verbunden und dazu über Signalleitungen 16 kontaktiert. Es kann eine direkte Verbindung vorgesehen sein, ebenso ist eine Verbindung über zwischen geschaltete elektronische Einrichtungen möglich.

Das erste Peltier-Element 13 ist so betrieben, dass es die Wärme der Muffel 3 aufnimmt und aufgrund der Temperaturdifferenz, die sich am Peltier-Element einstellt, in elektrischen Strom umwandelt. Dieser wird in einer Ausführung an dem zweiten Peltier-Element 15 zur Verfügung gestellt, welches diesen aufgrund der inversen Betriebsweise in eine Temperaturdifferenz umwandelt, und aufgrund dieser Temperaturdifferenz ein Kühlen des Schaltungsträgers 11 erzeugt wird.

Es wird somit auf einfache und effektive Weise die in dem Hausgerät selbst erzeugte Energie in Form von Wärme wiederverwendet und genutzt und insbesondere in der Kühlvorrichtung 12 dazu eingesetzt, dass eine weitere temperaturbeaufschlagte Komponente gekühlt werden kann.

Darüber hinaus umfasst der Backofen 1 eine Energierückgewinnungsvorrichtung 17. Diese umfasst ebenfalls das erste Peltier-Element 13, welches somit funktionell sowohl der Kühlvorrichtung 12 als auch der Energierückgewinnungsvorrichtung 17 zugeordnet ist.

Die Energierückgewinnungsvorrichtung 17 umfasst darüber hinaus zumindest eine Einrichtung 20, welche mit der die von dem ersten Peltier-Element 13 erzeugte elektrischen Energie in spezifischen Betriebsphasen energieversorgt wird.

Besonders vorteilhaft ist vorgesehen, dass dazu die Energierückgewinnungsvorrichtung 17 als Notstromvorrichtung betrieben wird. Gerade dann, wenn der Backofen 1, welcher mit einem externen Energieversorgungsnetz N verbunden ist und dadurch mit Energie versorgt wird, keine oder keine oder ausreichende Energieversorgung gewährleistet, kann durch diese interne Energierückgewinnungsvorrichtung 17 Strom bereitgestellt werden und ein weiterer Betrieb des Backofens 1 sichergestellt werden. Besonders vorteilhaft ist dies im Pyrolysebetrieb des Backofens 1, bei dem sehr hohe Temperaturen auftreten und bei dem ein hoher Energiebedarf erforderlich ist. Um diesen sicher durchführen zu können, auch dann, wenn beispielsweise ein Netzausfall vorliegt, wird durch diese interne Energiegewinnungsvorrichtung 17 des Backofens 1 auch solchen sicherheitskritischen Situationen Rechnung getragen und die Energieversorgung kann auch weiter aufrecht erhalten werden.

Es kann vorgesehen sein, dass der Backofen 1 einen Energiespeicher 18 aufweist, in dem die von dem Peltier-Element 13 erzeugte Energie gespeichert werden kann. So kann auch dann, wenn kein Notstrombetrieb gegeben ist, bereits elektrische Energie erzeugt und zwischengespeichert werden. Der Backofen 1 umfasst darüber hinaus eine Steuereinheit 19, mit welcher die Energieversorgung von Komponenten und das Kühlen gesteuert werden kann. Auch der in dem Energiespeicher 18 enthaltene Energieanteil kann diesbezüglich bedarfsgerecht an entsprechende Komponenteneinrichtungen abgegeben werden.

Neben der vorzugsweise vorgesehenen Ausgestaltung als Notstromvorrichtung der Energierückgewinnungsvorrichtung 17 kann darüber hinaus, wie bereits oben zur Erläuterung der Kühlvorrichtung 12 dargelegt, auch außerhalb dieses Notstrombetriebs die erzeugte elektrische Energie des ersten Peltier-Elements 13 sofort an andere Komponenten oder Einrichtungen des Backofens 1 zu deren elektrischen Energieversorgung gegeben werden.

Der von dem ersten Peltier-Element 13 erzeugte elektrische Strom kann somit abhängig vom Bedarf der zu kühlenden zweiten Komponente 9 beziehungsweise 11 und/oder abhängig von Betriebsphasen des Backofens 1 zumindest anteilig der Kühlvorrichtung 12 und/oder zumindest anteilig der Energierückgewinnungsvorrichtung 17 bereitgestellt werden. Auch für die Kühlvorrichtung 12 ist somit der von dem ersten Peltier-Element 13 erzeugte elektrische Strom zur Stromversorgung des zweiten Peltier-Elements 15 oder eines gegebenenfalls ersatzweise dafür vorgesehenen Gebläses eingesetzt. Darüber hinaus könnte auch zusätzlich vorgesehen sein, dass das Bedienmodul 9 mit elektrischer Energie, die vom ersten Peltier-Element 13 erzeugt ist, direkt versorgt wird.

**Bezugszeichenliste**

| | |
|---|---|
| 1 | Backofen |
| 2 | Garraum |
| 3 | Muffel |
| 4 | Decke |
| 5 | Rückwand |
| 6 | Boden |
| 7 | Beschickungsöffnung |
| 8 | Tür |
| 9 | Bedienmodul |
| 10 | Bedienelemente |
| 11 | Schaltungsträger |
| 12 | Kühlvorrichtung |
| 13, 15 | Peltier-Elemente |
| 14 | Außenseite |
| 16 | Signalleitungen |
| 17 | Energierückgewinnungsvorrichtung |
| 18 | Energiespeicher |
| 19 | Steuereinheit |
| 20 | Einrichtung |
| N | Energieversorgungsnetz |

## Patentansprüche

1. Hausgerät mit einer sich im Betrieb erwärmenden ersten Komponente (3) und einer Kühlvorrichtung (12) zum Kühlen zumindest einer zweiten Komponente (9, 11), wobei die Kühlvorrichtung (12) mit der ersten Komponente (3) des Hausgeräts (1) thermisch gekoppelt ist und die Kühlvorrichtung (12) zur Umwandlung der Wärme der ersten Komponente (3) in elektrischen Strom und zur Umwandlung des Stroms zur Kühlung der zweiten Komponente (9, 11) ausgebildet ist, und wobei die Kühlvorrichtung (12) ein erstes Peltier-Element (13) aufweist, welches mit der ersten Komponente (3) kontaktiert ist und zur Umwandlung der Wärme der ersten Komponente (3) in elektrischen Strom betrieben ist, **dadurch gekennzeichnet, dass** das Hausgeräts ein Backofen (1) ist, welcher als erste Komponente eine Muffel (3) aufweist, wobei das erste Peltier-Element (13) an der Muffel (3) angeordnet ist.

2. Hausgerät nach Anspruch 1, **dadurch gekennzeichnet, dass** die Kühlvorrichtung (12) eine Kühleinheit (15) aufweist, welche durch das Anlegen des elektrischen Stroms zum Kühlen der zweiten Komponente (9, 11) ausgebildet ist.

3. Hausgerät nach Anspruch 2, **dadurch gekennzeichnet, dass** die Kühleinheit ein Kühlluftgebläse ist.

4. Hausgerät nach Anspruch 2, **dadurch gekennzeichnet, dass** die Kühleinheit ein zweites Peltier-Element (15) ist, welches mit der zweiten Komponente (9, 11) kontaktiert ist und welches durch Anlegen des elektrischen Stroms zur Erzeugung einer Temperaturdifferenz ausgebildet ist, durch welche die zweite Komponente (9, 11) kühlbar ist.

5. Hausgerät nach Anspruch 4, **dadurch gekennzeichnet, dass** die beiden Peltier-Elemente (13, 15) direkt elektrisch verbunden sind.

6. Hausgerät nach einem der vorhergehenden Ansprüche, **dadurch gekennzeichnet, dass** das Hausgerät (1) eine Energierückgewinnungsvorrichtung (17) aufweist, welche mit der ersten Komponente (3) thermisch gekoppelt ist und zur Umwandlung von Wärme der ersten Komponente (3) in elektrische Energie ausgebildet ist, und mit einer Einrichtung (9, 11, 20) als elektrischen Verbraucher des Hausgeräts (1) gekoppelt ist, welcher die elektrische Energie bereitstellbar ist.

7. Hausgerät nach Anspruch 6, **dadurch gekennzeichnet, dass** die Energierückgewinnungsvorrichtung (17) als Notstromvorrichtung ausgebildet ist, insbesondere in einem Pyrolysebetrieb eines Backofens (1), durch welche die Einrichtung (9, 11, 20) mit Energie versorgt ist, wenn durch das externe Versorgungsnetz (N), mit welchem das Hausgerät (1) verbunden ist, keine oder keine ausreichende Energieversorgung gegeben ist.

8. Hausgerät nach Anspruch 6 oder 7, **dadurch gekennzeichnet, dass** das Hausgerät (1) eine Steuereinheit (19) aufweist, durch welche die Versorgung des Hausgeräts (1) durch das Versorgungsnetz (N) überwacht ist und durch welche die Betriebsart der Energierückgewinnungsvorrichtung (17) steuerbar ist.

9. Hausgerät nach einem der vorhergehenden Ansprüche 6 bis 8, **dadurch gekennzeichnet, dass** die Kühlvorrichtung (12) und die Energierückgewinnungsvorrichtung (17) ein funktionell beiden Vorrichtungen zugeordnetes Element, insbesondere das erste Peltier-Element (13), aufweisen, welches zur Umwandlung der Wärme der ersten Komponente (3) in elektrischen Strom ausgebildet ist, wobei der erzeugte Strom abhängig vom Bedarf der zu kühlenden zweiten Komponente (9, 11) und/oder abhängig von Betriebsphasen des Hausgeräts (1) zumindest anteilig der Kühlvorrichtung (12) und/oder zumindest anteilig der Energierückgewinnungsvorrichtung (17) bereitstellbar ist.

10. Hausgerät nach einem der vorhergehenden Ansprüche, **dadurch gekennzeichnet, dass** das erste Peltier-Element (13) an der Muffel (3) außerhalb an einer Muffeldecke (4) angeordnet ist.

11. Hausgerät nach einem der vorhergehenden Ansprüche, **dadurch gekennzeichnet, dass** die zu kühlende zweite Komponente ein Bedienmodul (9), insbesondere ein elektronischer Schaltungsträger (11) und/oder ein Motor, ist.

12. Verfahren zum Kühlen einer sich im Betrieb erwärmenden zweiten Komponente (9, 11) eines Hausgeräts (1), welches eine sich im Betrieb erwärmende erste Komponente (3) aufweist, bei welchem das Kühlen mittels einer Kühlvorrichtung (12) durchgeführt wird, wobei die Kühlvorrichtung (12) mit der ersten Komponente (3) thermisch gekoppelt wird und die Wärme der ersten Komponente (3) durch die Kühlvorrichtung (12) in elektrischen Strom umgewandelt wird, wobei der Strom für eine Kühleinheit (15) der Kühlvorrichtung (12) bereitgestellt wird und mit der Kühleinheit (15) die zweite Komponente (9, 11) gekühlt wird, und wobei die Kühlvorrichtung (12) ein erstes Peltier-Element (13) aufweist, welches mit der ersten Komponente (3) thermisch kontaktiert wird und zur Umwandlung der Wärme der ersten Komponente (3) in elektrischen Strom betrieben wird, **dadurch gekennzeichnet, dass** das Hausgeräts ein Backofen (1) ist, welcher als erste Komponente eine Muffel (3) aufweist, wobei das erste Peltier-Element (13) an der Muffel (3) angeordnet ist.

13. Verfahren nach Anspruch 12, **dadurch gekennzeichnet, dass** die Kühleinheit ein zweites Peltier-Element (15) ist, welches mit dem ersten Peltier-Element (13) elektrisch verbunden und mit der zweiten Komponente (9, 11) kontaktiert wird und welches durch Anlegen des elektrischen Stroms eine Temperaturdifferenz erzeugt, durch welche die zweite Komponente (9, 11) gekühlt wird.

14. Verfahren nach Anspruch 13, **dadurch gekennzeichnet, dass** das erste Peltier-Element (13) mit einer als erste Komponente ausgebildeten Muffel (3) eines Backofens (1) thermisch kontaktiert wird und durch das zweite Peltier-Element (15) ein als zweite Komponente ausgebildetes Bedienmodul (9, 11) des Backofens (1) gekühlt wird.

## Claims

1. Domestic appliance with a first component (3) that heats up during operation and a cooling device (12) for cooling at least one second component (9, 11), wherein the cooling device (12) is thermally coupled to the first component (3) of the domestic appliance (1) and the cooling device (12) is embodied for converting the heat of the first component (3) into electrical current and for converting the current for cooling the second component (9, 11) and wherein the cooling device (12) has a first Peltier element (13) which is in contact with the first component (3) and is operated to convert the heat of the first component (3) into electrical current, **characterised in that** the domestic appliance is a baking oven (1) which has a muffle (3) as its first component (3), wherein the first Peltier element (13) is disposed on the muffle (3).

2. Domestic appliance according to claim 1, **characterised in that** the cooling device (12) has a cooling unit (15) which is embodied, by the application of the electrical current, for cooling the second component (9, 11).

3. Domestic appliance according to claim 2, **characterised in that** the cooling unit is a cooling air blower.

4. Domestic appliance according to claim 2, **characterised in that** the cooling unit is a second Peltier element (15) which is in contact with the second component (9, 11) and which is embodied to create a temperature difference through which the second component (9, 11) is able to be cooled by application of the electrical current.

5. Domestic appliance according to claim 4, **characterised in that** the two Peltier elements (13, 15) are directly electrically connected.

6. Domestic appliance according to one of the preceding claims, **characterised in that** the domestic appliance (1) has an energy recovery device (17) which is thermally coupled to the first component (3) and is embodied for conversion of heat of the first component (3) into electrical energy, and is coupled to a device (9, 11, 20) as electrical consumer of the domestic appliance (1) to which the electrical energy is able to be provided.

7. Domestic appliance according to claim 6, **characterised in that** the energy recovery device (17) is embodied as an emergency power device, especially in a pyrolysis mode of a baking oven (1), by which the device (9, 11, 20) is supplied with energy when no energy or insufficient energy is provided by the external power supply network (N) to which the domestic appliance (1) is connected.

8. Domestic appliance according to claim 6 or 7, **characterised in that** the domestic appliance (1) has a control unit (19) by which the supply of energy to the domestic appliance (1) by the power supply network (N) is monitored and by which the operating mode of the energy recovery device (17) is able to be controlled.

9. Domestic appliance according to one of the preceding claims 6 to 8, **characterised in that** the cooling device (12) and the energy recovery device (17) have an element assigned functionally to both devices, especially the first Peltier element (13), which is embodied for converting the heat of the first component (3) into electrical current, wherein the created current, depending on demand, is able to be provided to the second component (9, 11) to be cooled and/or depending on operating phases of the domestic appliance (1), at least in part to the cooling device (12) and/or at least in part to the energy recovery device (17).

10. Domestic appliance according to one of the preceding claims 6 to 8, **characterised in that** the first LTA element (13) is disposed on the muffle (3) outside on a muffle cover (4).

11. Domestic appliance according to one of the preceding claims, **characterised in that** the second component to be cooled is an operating module (9), especially an electronic circuit carrier (11) and/or a motor.

12. Method for cooling a second component (9, 11) that heats up during operation of a domestic appliance (1) which has a first component (3) that heats up during operation, in which the cooling is carried out by means of a cooling device (12), wherein the cooling device (12) is thermally coupled to the first component (3) and the heat of the first component (3) is converted by the cooling device (12) into electrical current, wherein the current is provided for a cooling unit (15) of the cooling device (12) and the second component (9, 11) is cooled with the cooling unit (15) and wherein the cooling device (12) has a first Peltier element (13) which is in thermal contact with the first component (3) and is operated to convert the heat of the first component (3) into electrical current, **characterised in that** the domestic appliance is a baking oven (1) which has a muffle (3) as its first component, whereby the first Peltier element (13) is disposed on the muffle (3).

13. Method according to claim 12, **characterised in that** the cooling unit is a second Peltier element (15) which is electrically connected to the first Peltier element (13) and is in contact with the second component (9, 11) and which, by application of the electrical current, creates a temperature difference by which the second component (9, 11) is cooled

14. Method according to claim 13, **characterised in that** the first Peltier element (13) is in thermal contact with a muffle (3) of a baking oven (1) embodied as the first component and through the second Peltier element (15) an operating module (9, 11) of the baking oven (1) embodied as a second component is cooled.

## Revendications

1. Appareil ménager avec un premier composant (3) s'échauffant en cours de fonctionnement et un dispositif de refroidissement (12) destiné à un refroidissement d'au moins un second composant (9, 11), le dispositif de refroidissement (12) étant thermiquement couplé avec le premier composant (3) de l'appareil ménager (1) et le dispositif de refroidissement (12) étant prévu pour une conversion de la chaleur du premier composant (3) en courant électrique et pour une conversion du courant en vue d'un refroidissement du second composant (9, 11), et le dispositif de refroidissement (12) présentant un premier élément Peltier (13), qui est en contact avec le premier composant (3) et est utilisé pour une conversion de la chaleur du premier composant (3) en courant électrique, **caractérisé en ce que** l'appareil ménager est un four de cuisson (1), qui présente en tant que premier composant un moufle (3), le premier élément Peltier (13) étant agencé sur le moufle (3).

2. Appareil ménager selon la revendication 1, **caractérisé en ce que** le dispositif de refroidissement (12) présente une unité de refroidissement (15), qui est constituée en affectant le courant électrique au refroidissement du second composant (9, 11).

3. Appareil ménager selon la revendication 2, **caractérisé en ce que** l'unité de refroidissement est une soufflante d'air de refroidissement.

4. Appareil ménager selon la revendication 2, **caractérisé en ce que** l'unité de refroidissement est un second élément Peltier (15) qui est en contact avec le second composant (9, 11) et qui est constituée en affectant le courant électrique à une production d'une différence de température grâce à laquelle le second composant (9, 11) peut être refroidi.

5. Appareil ménager selon la revendication 4, **caractérisé en ce que** les deux éléments à Peltier (13, 15) sont directement reliés de manière électrique.

6. Appareil ménager selon l'une quelconque des revendications précédentes, **caractérisé en ce que** l'appareil ménager (1) présente un dispositif de récupération d'énergie (17), qui est couplé thermiquement avec le premier composant (3) et est prévu pour convertir de la chaleur du premier composant (3) en énergie électrique, et est couplé avec un appareil (9, 11, 20) tenant lieu de consommateur électrique de l'appareil ménager (1), auquel l'énergie électrique peut être mise à disposition.

7. Appareil ménager selon la revendication 6, **caractérisé en ce que** le dispositif de récupération d'énergie (17) est prévu en tant que dispositif d'alimentation électrique d'urgence grâce auquel l'appareil (9, 11, 20) est alimenté en énergie lorsqu'aucune alimentation en énergie ou aucune alimentation suffisante en énergie n'est fournie par le réseau externe d'alimentation (N) auquel est relié l'appareil ménager (1) en particulier pour un fonctionnement pyrolytique d'un four de cuisson (1).

8. Appareil ménager selon la revendication 6 ou 7, **caractérisé en ce que** l'appareil ménager (1) présente une unité de commande (19) grâce à laquelle l'alimentation de l'appareil ménager (1) par le réseau d'alimentation (N) est surveillée et grâce à laquelle le type de fonctionnement du dispositif de récupération d'énergie (17) peut être commandé.

9. Appareil ménager selon l'une quelconque des revendications 6 à 8, **caractérisé en ce que** le dispositif de refroidissement (12) et le dispositif de récupération d'énergie (17) présentent un élément affecté de manière fonctionnelle aux deux dispositifs, en particulier le premier élément Peltier (13), qui est prévu pour convertir la chaleur du premier composant (3) en courant. électrique, le courant produit étant mis à disposition du dispositif de refroidissement (12) au moins de manière proportionnée et/ou du dispositif de récupération d'énergie (17) au moins de manière proportionnée en fonction du besoin du second composant (9, 11) à refroidir et/ou en fonction des phases de fonctionnement de l'appareil ménager (1).

10. Appareil ménager selon l'une quelconque des revendications précédentes, **caractérisé en ce que** le premier élément Peltier (13) est agencé sur le moufle (3) à l'extérieur d'un couvercle de moufle (4).

11. Appareil ménager selon l'une quelconque des revendications précédentes, **caractérisé en ce que** le second composant à refroidir est un module de service (9), en particulier un support de circuit électronique (11) et/ou un moteur.

12. Procédé de refroidissement d'un second composant (9, 11), s'échauffant en en cours de fonctionnement, d'un appareil ménager (1), qui présente un premier composant (3) s'échauffant en cours de fonctionnement, dans lequel le refroidissement est mis en oeuvre au moyen d'un dispositif de refroidissement (12), le dispositif de refroidissement (12) étant thermiquement couplé avec le premier composant (3) et la chaleur du premier composant (3) étant convertie en courant électrique grâce au dispositif de refroidissement (12), le courant étant mis à disposition d'une unité de refroidissement (15) du dispositif de refroidissement (12) et le second composant (9, 11) étant refroidi par l'unité de refroidissement (15), et le dispositif de refroidissement (12) présentant un premier élément Peltier (13) qui est thermiquement en contact avec le premier composant (3) et réalisé pour convertir la chaleur du premier composant (3) en courant électrique, **caractérisé en ce que** l'appareil ménager est un four de cuisson (1) qui présente en tant que premier composant un moufle (3), le premier élément Peltier (13) étant agencé sur le moufle (3).

13. Procédé selon la revendication 12, **caractérisé en ce que** l'unité de refroidissement est un second élément Peltier (15), qui est relié électriquement au premier élément Peltier (13) et est en contact avec le second composant (9, 11) et qui, grâce à l'affectation du courant électrique, produit une différence de température grâce à laquelle le second composant (9, 11) est refroidi.

14. Procédé selon la revendication 13, **caractérisé en ce que**
le premier élément Peltier (13) est thermiquement en contact avec un moufle (3), prévu pour tenir lieu de premier composant, d'un four de cuisson (1) et un module de service (9, 11), prévu pour tenir lieu de second composant, du four de cuisson (1) et refroidi grâce au second élément Peltier (15).
